# EUROPÄISCHE PATENTSCHRIFT

(11) **EP 1 205 938 B1**
(45) Veröffentlichungstag und Bekanntmachung des Hinweises auf die Patenterteilung: **05.11.2008**
(21) Anmeldenummer: 01122878.0
(22) Anmeldetag: 24.09.2001
(51) Int. Cl.: G11C 29/00

(54) **Integrierte Schaltung mit Testbetriebsart und Verfahren zum Testen einer Vielzahl solcher integrierter Schaltungen**
Integrated circuit with test mode and method for testing a plurality of such circuits
Circuit intégré avec mode test et procédé pour le test d'une pluralité desdits circuits

(30) Priorität: 20.10.2000 DE 10052211
(43) Veröffentlichungstag der Anmeldung: 15.05.2002
(73) Patentinhaber: Infineon Technologies AG, 81669 München (DE)
(72) Erfinder: Dietrich, Stefan, Dr., 82299 Türkenfeld (DE); Heyne, Patrick, 81243 München (DE); Marx, Thilo, 78048 Villingen-Schwenningen (DE); Schoeniger, Sabine, 83734 Hausham (DE); Sommer, Michael, 81541 München (DE); Hein, Thomas, 81379 München (DE); Markert, Michael, 86152 Augsburg (DE); Partsch, Torsten, 27514 Chapel Hill, NC (US); Schroegmeier, Peter, 81547 München (DE); Weis, Christian, 82110 Germering (DE)
(74) Vertreter: Epping - Hermann - Fischer

(56) Entgegenhaltungen:
- DE-A1- 19 937 320
- US-A- 5 991 232

## Beschreibung

Die Erfindung betrifft eine integrierte Schaltung, die in einer Normalbetriebsart und in einer Testbetriebsart betreibbar ist. Über einen Eingangsanschluß wird ein Steuersignal zur Steuerung eines Schaltmittels eingespeist. Die Erfindung betrifft außerdem ein Verfahren zum Testen einer Vielzahl von solchen ausgangsseitig parallel geschalteten integrierten Schaltungen.

Integrierte Schaltungen, insbesondere Halbleiterspeicher, werden nach der Herstellung getestet, um deren Funktionalität sicherzustellen. Hierzu werden die Speicherchips von einem Testautomaten in den Testbetrieb versetzt. Eine Vielzahl von Speicherchips wird parallel angesteuert und getestet. Ausgangsseitig sind die Speicherchips parallel geschaltet. Es ist dafür Sorge zu tragen, daß beim Auslesen des Testergebnisses zwei Chips nicht etwa gleichzeitig ein Signal an den Tester über den gemeinsamen Anschluß ausgeben. Daher ist für diesen Fall nur einer der Speicherchips zur Ausgabe eines Testergebnisses an den Testautomaten zu aktivieren, die anderen der Speicherchips sind während dieses Zeitraums von der Ausgabe eines Testergebnisses an den Testautomaten zu deaktivieren.

Heutzutage sind insbesondere Halbleiterspeicher mit synchroner Betriebsart gefragt, sogenannte SDRAMs (Synchronous Dynamic Random Access Memory). Es gibt DDR SDRAMs, sogenannte Double Data Rate SDRAMs, die Information bei steigender und fallender Flanke des die synchrone Betriebsart steuernden Taktsignals verarbeiten. Der Freiraum bei der schaltungstechnischen Umsetzung von Konzepten für SDRAMs und DDR SDRAMs ist beschränkt, da die nach außen hin gerichtete Funktionalität dieser Halbleiterspeicher verschiedenen Standards, z.B. durch JEDEC genormt, genügen muß.

Im Dokument JEDEC Solid State Technology Association: Double Date Rate (DDR) SDRAM Specification, JEDEC Standard No. 79, Arlington, Juni 2000, Seiten i; 1 bis 15 ist ein Halbleiterspeicher beschrieben, bei dem im Normalbetrieb in Abhängigkeit von einem eingangsseitig zuführbaren Steuersignal DM bei einem Schreibzugriff ein Dateneingangssignalpfad ein- und ausschaltbar ist. Die an den Datenbusanschlüssen DQ0 bis DQ7 anstehenden Daten werden bei einem Low-Pegel des Steuersignals DM in den Speicher geschrieben und bei einem High-Pegel ausmaskiert. Der Halbleiterspeicher umfaßt ansonsten Datenausgangstreiber und einen Dateneingangssignalpfad. Über ein Mode-Register kann zwischen Normalbetrieb und einem herstellerspezifischen Testbetrieb umgeschaltet werden.

In der DE 199 37 320 A1 ist ein Halbleiterspeicher beschrieben, bei dem ein Testsignal DQM über einen externen Anschluß zugeführt wird. Im Testbetrieb wird davon abhängig ein Signal PSE zur Lesefreigabe erzeugt. Während des Normalbetriebs wird ein internes Lesefreigabe-Steuersignal erzeugt.

Die Aufgabe der Erfindung besteht darin, eine integrierte Schaltung der eingangs genannten Art anzugeben, die standardkonform ist und mit geringem externem Aufwand testbar ist. Darüber hinaus besteht eine Aufgabe der Erfindung darin, ein Verfahren zum Testen einer Vielzahl von solchen Schaltungen anzugeben, bei dem der externe Aufwand gering ist.

Gemäß der Erfindung wird die Aufgabe betreffend die integrierte Schaltung gelöst durch eine integrierte Schaltung mit einer ersten Betriebsart, in der ein Funktionstest einer Funktionseinheit der integrierten Schaltung durchgeführt wird, einer zweiten Betriebsart, in der die Funktionseinheit in Normalbetriebsart betrieben wird, einem Datenausgangstreiber und einem Dateneingangssignalpfad, die jeweils mit der Funktionseinheit und Anschlüssen für Datensignale zum Zu- und Abführen von Datenwerten gekoppelt sind, einem Eingangsanschluß zur Zuführung eines Steuersignals, und mit einer Steuerungsschaltung, durch die in Abhängigkeit von der eingestellten Betriebsart bewirkt wird, daß in der Normalbetriebsart durch verschiedene Zustände des Steuersignals der Dateneingangssignalpfad ein- oder ausgeschaltet wird, und daß in der Testbetriebsart der Datenausgangstreiber durch verschiedene Zustände des Steuersignals ein- oder ausgeschaltet wird.

Betreffend das Verfahren wird diese Aufgabe gelöst durch ein Verfahren zum Testen einer Vielzahl von solchen integrierten Schaltungen, bei dem die integrierten Schaltungen bezüglich der Anschlüsse der Datensignale parallel geschaltet sind und bei der jeweils nur eines der den Eingangsanschlüssen der integrierten Schaltkreise zuführbaren Steuersignale einen ersten Zustand einnimmt, und alle anderen dieser Steuersignale gemeinsam einen anderen Zustand einnehmen.

Insbesondere DDR SDRAMs besitzen den oben genannten Eingangsanschluß zur Zuführung eines Steuersignals ohnehin. Gemäß dem JEDEC-Standard wird dieser Anschluß DM-Pad genannt. Er ermöglicht im Normalbetrieb des Speicherchips ein byteweises maskieren der Daten in Schreibrichtung. Dies bedeutet, daß dann, wenn das am DM-Pad anliegende Steuersignal einen vorgegebenen Zustand aufweist, z.B. einen High-Pegel, das vom DM-Pad beeinflußbare Datenbyte blockiert und nicht vom Speicherchip intern empfangen wird. Durch die von der Erfindung zusätzlich vorgesehenen Maßnahmen wird auf einfache Weise mit geringem Schaltungsaufwand ermöglicht, daß im Testbetrieb das parallele Treiben von Testsignalergebnissen unterbunden wird.

So ist ein Demultiplexer vorgesehen, welcher eingangsseitig mit dem DM-Pad verbunden ist. Ausgangsseitig wird der Demultiplexer im Normalbetrieb dazu verwendet, die normale Funktionalität des am DM-Pad eingegebenen Steuersignals an die übrigen Funktionseinheiten im Speicherchip weiter zu leiten. So sind im Normalbetrieb die Dateneingangssignalpfade durch das am DM-Pad eingegebene Steuersignal maskierbar, d.h. abschaltbar. Im Testbetrieb steuert dieser Demultiplexer ausgangsseitig den Umschaltsteuereingang eines Multiplexers. Dieser bewirkt, daß abhängig vom am DM-Pad eingegebenen Signal entweder ein konstanter Pegelwert weitergeleitet wird oder ein anderweitig erzeugtes Steuersignal, welches den Lesebetrieb innerhalb des Speicherchips steuert. Der Ausgang dieses Multiplexers steuert einen der Datenausgangstreiber des Speicherchips an. Wenn im Testbetrieb der Demultiplexer auf den letztgenannten Ausgang umgeschaltet ist, wird abhängig vom am DM-Pad eingegebenen Signal der Multiplexer wahlweise auf den konstanten Pegel oder das Lesesteuersignal umgeschaltet. Im ersteren Fall wird der Datenausgangstreiber abgeschaltet, im zweiten Fall ist er abhängig vom Lesesteuersignal triggerbar.

Insgesamt wird also ermöglicht, daß durch externe Einprägung des Steuersignals am DM-Pad durch den Testautomaten chipintern der Datenausgangstreiber eines Datensignalanschlusses an- oder abgeschaltbar ist. Somit wird dem Testautomaten ermöglicht, diesen einen oder mehrere der Datensignalausgänge eines einzigen Speicherchips zu aktivieren, und Testausgangsdaten abzufragen. Es wird vermieden, daß mehrere Speicherchips parallel treiben und deren Ausgangssignale dadurch unlesbar werden. Der besondere Vorteil der Erfindung liegt darin, daß wenig zusätzlicher Aufwand chipintern wie auch auf Seite des Testautomaten erforderlich ist. Das DM-Pad ist aus anderen Gründen ohnehin mit einem Kanal des Testautomaten verbunden. Es sind daher keine über die standardgemäß erforderlichen TesterKanäle hinaus benötigten Kanäle zur Ansteuerung etwaiger Pads des zu testenden Chips erforderlich. Es sind dadurch eine Vielzahl von DDR SDRAMs parallel steuerbar, was den Ausnutzungsgrad des Testautomaten und schließlich die Testkosten vergleichsweise gering hält.

Die verschiedenen Betriebsartzustände des Halbleiterchips werden über die Adreßeingänge dem Speicherchip mitgeteilt. Im Normalbetrieb werden an die Adreßeingänge die Adressen zur Auswahl einer oder mehrerer der Speicherzellen des Speicherchips eingegeben. Darüberhinaus dienen diese Adreßeingänge dazu, Steuersignale einzugeben, die eine bestimmte Abfolge von Datenbits meist innerhalb besonderer Zeitfenster, die im Normalbetrieb nicht zulässig sind, umfassen. Danach wird der Speicherchip zuerst aus der voreingestellten Normalbetriebsart in die Testbetriebsart, genannt TMCOMP, umgeschaltet. Während des TMCOMP-Modus wird beispielsweise durch einen intern weitgehend selbständig ablaufenden Test (Built-In-Selftest) eine Information über den Fehlerzustand bestimmter Bereiche des Speicherzellenfeldes ermittelt. Diese Information ist nachfolgend an den Tester auszugeben, damit dieser das Ersetzen von defekten Speicherzellen oder Schaltungsblöcken durch entsprechende redundante Elemente steuert. Gemäß der Erfindung wird ein weiterer Testmodus erzeugt. Dieser wird wiederum durch eine vorvereinbarte Befehlsfolge, die über die Adreßeingänge des Speicherchips eingegeben wird, eingestellt, sog. TMRDIS-Modus. Das den TMRDIS-Modus anzeigende Steuersignal steuert den ersten Multiplexer und schaltet ihn von Normalbetrieb oder auch TMCOMP-Betrieb auf den TMRDIS-Betrieb um, so daß ein transparenter Signalpfad vom DM-Pad zum Steuereingang des Multiplexers geschaltet ist. Anschließend wird durch entsprechende Befehlseingabe über die Adreßanschlüsse vom TMRDIS-Modus auf dem TMCOMP-Modus zurückgeschaltet.

Weitere Ausgestaltungen der Erfindung sind in verschiedenen abhängigen Ansprüchen angegeben. So ist das DM-Pad ein gemäß dem JEDEC-Standard bei einem DDR SDRAM vorzusehende Anschlußfläche, welche meist über einen Bonddraht an einen Anschlußstift des Gehäuses zu kontaktieren ist. Das DM-Pad ist somit von außen direkt über einen Gehäusepin ansteuerbar. Die vom DM-Pad bei einem Schreibvorgang im Normalbetrieb maskierbare Anzahl von Datensignalen beträgt 8 Bit, ein sogenanntes Byte. Die den Multiplexer ansteuernden Signale weisen einen Low-Pegel für den konstanten Pegelwert auf. Das Lesebetriebsartsignal hat einen Low-Pegel während des Schreibbetriebs und einen High-Pegel zur Aktivierung des Lesebetriebs. Ein abgeschalteter Ausgangstreiber befindet sich in einem Tristate-Modus, d.h. hochohmig.

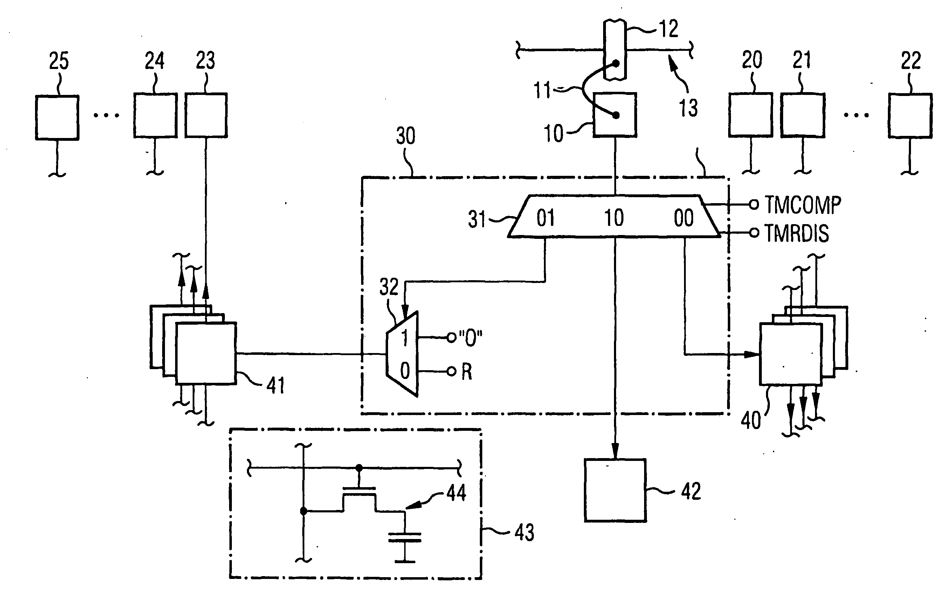

Nachfolgend wird die Erfindung anhand des in der Zeichnung dargestellten Ausführungsbeispiels im Detail erläutert. Es zeigt einen im Zusammenhang mit der Erfindung relevanten Ausschnitt aus einem DDR SDRAM.

Der in der Figur dargestellte Ausschnitt aus einem DDR SDRAM zeigt ein DM-Pad 10, eine Anzahl von Adreßpads 20, 21, 22 sowie eine Anzahl von Datenein-/Ausgabepads 23, 24, 25. Die Anzahl der Adreßpads richtet sich nach der Menge individuell zu adressierender Speicherzellen. Die Anzahl der Datenein-/Ausgabepads kann beispielsweise 32 Bit, also 4 Byte, betragen. Das DM-Pad 10 ist über einen Bonddraht 11 mit einem Anschlußstift 12 eines Gehäuses 13 verbunden. Schaltungsintern ist das DM-Pad 10 mit einer Steuerungsschaltung 30 verbunden. Die Steuerungsschaltung 30 bewirkt, daß in einem Normalbetrieb der je einem der Datenpads 23, 24, 25 zugeordnete Eingangssignalpfad 40 maskierbar ist, während im Testbetrieb ein mit den Datenanschlüssen 23, 24, 25 verbundener Datenausgangstreiber 41 abschaltbar ist.

Im Detail weist die Steuerungsschaltung 30 einen Demultiplexer 31 auf. Dieser ist eingangsseitig mit dem DM-Pad 10 verbunden. Steuersignalseitig werden die beiden Steuersignale TMCOMP sowie TMRDIS dem Demultiplexer 31 zugeführt. Das Signal TMCOMP gibt an, daß Testbetrieb vorliegt, das Signal TMRDIS gibt an, daß ein besonderer weiterer Modus während des Testbetriebs eingeschaltet ist. Ein erster Ausgang 00 des Multiplexers 31 ist im Normalbetrieb freigeschaltet und steuert die mit den Datensignalpads 23, 24, 25 verbundenen Dateneingangssignalpfade 40 an. Je nach Signalzustand des am DM-Pad eingespeisten Signals sind die byteweise parallel angesteuerten Dateneingangssignalpfade 40 maskierbar, d.h. abschaltbar. Ein zweiter Ausgang 10 des Multiplexers 31 wird im TMCOMP-Modus aktiviert. Die dieser Betriebsart zugeordneten Funktionseinheiten sind mit 42 dargestellt und bewirken, daß Speicherzellen 44 im Speicherzellenfeld 43 auf Funktionalität getestet werden. Das Testergebnis der einen Built-In-Selftest ausführenden Schaltungen 42 wird bei Testende über einen Datenausgangstreiber 41 an die Datensignalpads 23, 24, 25 weitergeleitet. Ein Ausgang 01 des Demultiplexers 31 wird in der Betriebsart TMRDIS freigeschaltet. Er ist mit dem Steuereingang eines Multiplexers 32 verbunden. In Abhängigkeit von dem am DM-Pad 10 anliegenden Steuersignal wird der Multiplexer 32 entweder in seiner Stellung 1 oder in seiner Stellung 0 betrieben. Bei Stellung 1 wird ein konstanter Pegel, z.B. "0", weitergeleitet, welcher die mit den Datensignalpads 23, 24, 25 verbundenen Ausgangstreiber 41 ansteuert. In der Stellung 0 wird ein die Lesebetriebsart steuerndes Signal R auf den Ausgang des Multiplexers 32 weiter geschaltet. In der Stellung 1 sind die Ausgangstreiber 41 abgeschaltet, in der Stellung 0 werden sie je nach Zustand des Signals R ein- oder ausgeschaltet. Es sind jeweils ein Byte, d.h. eine Anzahl von 8 Dateneingangssignalpfaden 40 sowie Datenausgangstreibern 41 gleichzeitig vom Ausgang 00 des Demultiplexers 31 bzw. vom Ausgang des Multiplexers 32 ansteuerbar.

Die Signale TMCOMP sowie TMRDIS werden chipintern erzeugt, nachdem über die Adreßpads 20, 21, 22 eine geeignete Befehlsfolge eingegeben wurde. Die durch das Steuersignal TMCOMP angezeigte Testbetriebsart ist herkömmlicherweise bei einem DDR SDRAM vorhanden. Die Betriebsart TMRDIS und das diese Betriebsart anzeigende Steuersignal TMRDIS sind in Zusammenhang mit der Erfindung neu eingeführt. Durch Aktivierung der Testbetriebsart TMRDIS wird ein Signalpfad vom DM-Pad 10 zum Steueranschluß des Multiplexers 32 geschaltet, so daß das vom Testautomaten über den Anschlußpin 12 und das DM-Pad 10 eingespeiste Steuersignal den Multiplexer 32 wahlweise in Stellung 1 oder in Stellung 0 steuern kann, so daß dann entweder in Stellung 1 die byteweise zusammengefaßten Ausgangstreiber 41 sicher abgeschaltet sind oder in Stellung 0 entsprechend dem Lesesteuersignal R frei geschaltet werden.

Mit Einführung des zusätzlichen Testmodus TMRDIS ist es möglich, daß dem DM-Pad 10 eine zusätzliche Funktionalität während des Testbetriebs zugewiesen wird. Durch geeignete Signaleinprägung des am DM-Pad 10 anliegenden Steuersignals durch den Testautomaten wird ermöglicht, daß die Ausgangstreiber 41 frei geschaltet werden. Üblicherweise wird eine Vielzahl von gleichartigen Speicherchips parallel getestet. Die Ausgangspads 23, 24, 25 dieser verschiedenen zu testenden Speicherchips sind parallel an entsprechende Testerkanäle verdrahtet. Gemäß dem JEDEC-Standard ist dem DM-Pad 10 ohnehin ein eigener Testerkanal zugeordnet. Indem während des TMRDIS-Modus, der vom Testautomaten an den Chip eingegeben wird, jeweils nur eines der DM-Pads mit einem High-Pegel angesteuert wird und somit der Multiplexer 32 nur eines der Vielzahl an parallel geschalteten Speicherchips in Stellung 1 gebracht wird, wird sichergestellt, daß nur ein byteweiser Satz von Ausgangstreibern 41 frei geschaltet ist, um das im TMCOMP-Modus erzeugte Testausgangssignal über die Datenpads 23, 24, 25 auszugeben. Zur Ausgabe dieser Testergebnisse des TMCOMP-Modus von verschiedenen Speicherchips an den Testautomaten wird aufeinander folgend abwechselnd nur das DM-Pad eines der parallel getesteten Speicherchips mit einem High-Pegel beaufschlag. Im Zusammenspiel ergibt sich, daß die ausgangsseitig parallel verdrahteten Speicherchips bei Ausgabe eines Testergebnisses nicht gegeneinander treiben.

Da das DM-Pad 10 ohnehin mit einem separaten Kanal des Testautomaten verbunden ist, ist auf Seite des Testautomaten kein zusätzlicher Verdrahtungsaufwand mehr erforderlich. Der Schaltungsaufwand innerhalb des Speicherchips ist, wie aus der Figur deutlich zu erkennen ist, relativ gering. Durch Zuweisung der oben beschriebenen zusätzlichen Funktionalität zum ohnehin vorhandenen DM-Pad wird ermöglicht, daß eine möglichst große Vielzahl von Speicherchips parallel testbar ist.

## Patentansprüche

1. Integrierte Schaltung mit
- einer ersten Betriebsart, in der eine Funktionseinheit (43, 44) in einer Testbetriebsart (TMCOMP, TMDRIS) betrieben wird, in der ein Funktionstest der Funktionseinheit (43, 44) der integrierten Schaltung durchgeführt wird,
- einer zweiten Betriebsart, in der die Funktionseinheit in Normalbetriebsart betrieben wird,
- einem Datenausgangstreiber (41) und einem Dateneingangssignalpfad (40), die jeweils mit der Funktionseinheit (43, 44) und Anschlüssen für Datensignale (23, 24, 25) zum Zu- und Abführen von Datenwerten gekoppelt sind,
- einem Eingangsanschluß (10) zur Zuführung eines Steuersignals, **gekennzeichnet durch**
- eine Steuerungsschaltung (30), **durch** die in Abhängigkeit von der eingestellten Betriebsart bewirkt wird, daß
- - in der Normalbetriebsart **durch** verschiedene Zustände des Steuersignals der Dateneingangssignalpfad (40) ein- oder ausgeschaltet wird, und daß
- - in der Testbetriebsart (TMCOMP, TMDRIS) der Datenausgangstreiber (41) **durch** verschiedene Zustände des Steuersignals ein- oder ausgeschaltet wird.

2. Integrierte Schaltung nach Anspruch 1,
**dadurch gekennzeichnet, daß**
die Steuerungsschaltung (30) einen Demultiplexer (31) umfaßt, der eingangsseitig mit dem Eingangsanschluß (10) verbunden ist und von einem zweiten Steuersignal (TMDRIS) gesteuert wird,
daß einer der Ausgänge (01) des Demultiplexers (31) einen Multiplexer (32) steuert, dem eingangsseitig ein konstanter Signalpegel (0) sowie ein drittes Steuersignal (R), durch das eine Lesebetriebsart eingestellt wird, zugeführt wird, und daß durch den Multiplexer (32) ausgangsseitig
der Datenausgangsstreiber (41) ein- oder ausgeschaltet wird.

3. Integrierte Schaltung nach Anspruch 2,
**dadurch gekennzeichnet, daß**
der Eingangsanschluß (10) eine Anschlußfläche ist, an die ein Gehäusepin (12) kontaktiert ist.

4. Integrierte Schaltung nach einem der Ansprüche 2, bis 3,
**dadurch gekennzeichnet, daß**
Anschlüsse für Adreßsignale (20, 21, 22) vorgesehen sind, durch die eine Adresse einer in der Funktionseinheit (43) angeordneten Speicherzelle (44) zugeführt wird, und daß das zweite Steuersignal (TMRDIS) über die Adreßanschlüsse (20, 21, 22) zugeführt wird.

5. Integrierte Schaltung nach einem der Ansprüche 2 bis 4,
**dadurch gekennzeichnet, daß**
der konstante Signalpegel ein Low-Pegel ist.

6. Integrierte Schaltung nach Anspruch 4,
**dadurch gekennzeichnet, daß**
über die Anschlüsse (23, 24, 25) für Datensignale die Datenwerte für die Speicherzellen (41) der Funktionseinheit (43) zu- und abgeführt werden, daß je ein Datenausgangstreiber (41) und je ein Dateneingangssignalpfad (40) mit einem der Anschlüsse (23, 24, 25) für Datensignale gekoppelt ist, daß die Datenausgangstreiber (41) vom Ausgang des Multiplexers (32) gleichzeitig angesteuert werden und daß die Dateneingangssignalpfade (40) von einem der Ausgänge (00) des Demultiplexers (31) gleichzeitig angesteuert werden.

7. Integrierte Schaltung nach Anspruch 6,
**dadurch gekennzeichnet, daß**
die Anzahl von Anschlüssen genau acht Anschlüsse zur Bildung eines Bytes umfaßt.

8. Verfahren zum Testen einer Vielzahl von integrierten
Schaltungen nach einem der Ansprüche 1 bis 7, bei dem die integrierten Schaltungen bezüglich der Anschlüsse (23, 24, 25) für die Datensignale parallel geschaltet sind und bei dem jeweils nur eines der den Eingangsanschlüssen (10) der integrierten Schaltkreise jeweils getrennt zugeführten Steuersignale einen ersten Zustand einnimmt, und alle anderen dieser Steuersignale gemeinsam einen anderen Zustand einnehmen.

## Claims

1. Integrated circuit having
- a first operating mode, in which a functional unit (43, 44) is operated in a test operating mode (TMCOMP, TMRDIS), in which a functional test of the functional unit (43, 44) of the integrated circuit is carried out,
- a second operating mode, in which the functional unit is operated in the normal operating mode,
- a data output driver (41) and a data input signal path (40), which are in each case coupled to the functional unit (43, 44) and terminals for data signals (23, 24, 25) for feeding in and picking off data values,
- an input terminal (10) for feeding in a control signal, **characterized by**
- a control circuit (30), which, in a manner dependent on the operating mode set, has the effect that
- - in the normal operating mode, the data input signal path (40) is switched on or off as a result of different states of the control signal, and that
- - in the test operating mode (TMCOMP, TMRDIS), the data output driver (41) is switched on or off as a result of different states of the control signal.

2. Integrated circuit according to Claim 1,
**characterized in that**
the control circuit (30) comprises a demultiplexer (31), which, on the input side, is connected to the input terminal (10) and is controlled by a second control signal (TMRDIS),
**in that** one of the outputs (01) of the demultiplexer (31) controls a multiplexer (32), to which are fed, on the input side, a constant signal level (0) and also a third control signal (R), which sets a read operating mode, and **in that** the data output driver (41) is switched on or off by the multiplexer (32) on the output signal.

3. Integrated circuit according to Claim 2,
**characterized in that**
the input terminal (10) is a terminal pad to which a housing pin (12) is contact-connected.

4. Integrated circuit according to one of Claims 2 to 3,
**characterized in that**
terminals for address signals (20, 21, 22) are provided, by means of which an address is fed to a memory cell (44) arranged in the functional unit (43), and **in that** the second control signal (TMRDIS) is fed in via the address terminals (20, 21, 22).

5. Integrated circuit according to one of Claims 2 to 4,
**characterized in that**
the constant signal level is a low level.

6. Integrated circuit according to Claim 4,
**characterized in that**
the data values for the memory cells (41) of the functional unit (43) are fed in and picked off via the terminals (23, 24, 25) for data signals, **in that** a respective data output driver (41) and a respective data input signal path (40) are coupled to one of the terminals (23, 24, 25) for data signals, **in that** the data output drivers (41) are driven simultaneously by the output of the multiplexer (32), and **in that** the data input signal paths (40) are driven simultaneously by one of the outputs (00) of the demultiplexer (31).

7. Integrated circuit according to Claim 6,
**characterized in that**
the number of terminals comprises exactly eight terminals for forming a byte.

8. Method for testing a multiplicity of integrated circuits according to one of Claims 1 to 7, in which the integrated circuits are connected in parallel with regard to the terminals (23, 24, 25) for the data signals, and in which in each case only one of the control signals that are in each case fed separately to the input terminals (10) of the integrated circuits assumes a first state, and the rest of these control signals all jointly assume another state.

## Revendications

1. Circuit intégré comprenant
- un premier type de fonctionnement, dans lequel un test(TMCOMP, TMRDIS) de fonctionnement de l'unité (43, 44) de fonction du circuit intégré est effectué ;
- un deuxième type de fonctionnement, dans lequel l'unité de fonction est mise en fonctionnement dans un type de fonctionnement normal ;
- un étage (41) de sortie de données et un trajet (40) de signal d'entrée de données, qui sont couplés, respectivement, à l'unité (43, 44) de fonction et à des bornes pour des signaux (23, 24, 25) de données pour entrer et sortir des valeurs de données ; et
- une borne (10) d'entrée pour l'entrée d'un signal de commande,
**caractérisé par**
- un circuit (30) de commande, par lequel il est provoqué, en fonction du type de fonctionnement réglé, que
-- dans le type de fonctionnement normal, le trajet (40) de signal d'entrée de données est mis en circuit ou mis hors circuit par des états différents du signal de commande ; et que
-- dans le type (TMCOMP, TMRDIS) de fonctionnement de test, l'étage (41) de sortie de données est mis en circuit ou mis hors circuit par des états différents du signal de commande.

2. Circuit intégré suivant la revendication 1,
**caractérisé**
**en ce que** le circuit (30) de commande comprend un démultiplexeur (31) qui est relié du côté entrée à la borne (10) d'entrée et qui est commandé par un deuxième signal (TMRDIS) de commande ;
**en ce que** l'une des sorties (01) du démultiplexeur (31) commande un multiplexeur (32) auquel est envoyé du côté entrée un niveau (0) de signal constant, ainsi qu'un troisième signal (R) de commande par lequel un type de fonctionnement en lecture est établi et en ce que l'étage (41) de sortie de données du côté sortie est mis en circuit ou mis hors circuit par le multiplexeur (32).

3. Circuit intégré suivant la revendication 2,
**caractérisé**
**en ce que** la borne (10) d'entrée est une surface de borne, sur laquelle est mise en contact une broche (12) de boîtier.

4. Circuit intégré suivant l'une des revendications 2 à 3,
**caractérisé**
**en ce qu'**il est prévu des bornes pour des signaux (20, 21, 22) d'adresse, par lesquelles une adresse d'une cellule (44) de mémoire disposée dans l'unité (43) de fonction est entrée et en ce que le deuxième signal (TMRDIS) de commande est entré par les bornes (20, 21, 22) d'adresse.

5. Circuit intégré suivant l'une des revendications 2 à 4,
**caractérisé**
**en ce que** le niveau de signal contant est un niveau bas.

6. Circuit intégré suivant la revendication 4,
**caractérisé**
**en ce que** les valeurs de données pour les cellules (41) de mémoire de l'unité (43) de fonction sont entrées et sorties par les bornes (23, 24, 25), en ce que, respectivement, un étage (41) de sortie de données, et, respectivement, un trajet (40) de signal d'entrée de données, est couplé à l'une des bornes (23, 24, 25) pour des signaux de données, en ce que les étages (41) de sortie de données sont commandés simultanément par la sortie du multiplexeur (32) et en ce que les trajets (40) de signal d'entrée de données sont commandés simultanément par l'une des sorties (00) du démultiplexeur (31).

7. Circuit intégré suivant la revendication 6,
**caractérisé**
**en ce que** le nombre des bornes comprend exactement huit bornes pour former un octet.

8. Procédé de test d'une pluralité de circuits intégrés suivant l'une des revendications 1 à 7, dans lequel on monte les circuits intégrés en parallèle pour ce qui concerne les bornes (23, 24, 25) pour les signaux de données et dans lequel, respectivement, seulement l'un des signaux de commande appliqués, respectivement, séparément aux bornes (10) d'entrée des circuits intégrés prend un premier état et tous les autres de ces signaux de commande prennent conjointement un autre état.
